# EUROPEAN PATENT SPECIFICATION

(11) **EP 3 071 727 B1**
(45) Date of publication and mention of the grant of the patent: **01.05.2019**
(21) Application number: 14861864.8
(22) Date of filing: 17.11.2014
(51) Int. Cl.: C23C 14/24, C23C 14/06, F01D 5/28

(54) **AIRFOIL HAVING A VARIABLE COATING**
SCHAUFELBLATT MIT VARIABLER BESCHICHTUNG
PROFIL D'AUBE COMPRENANT UN REVÊTEMENT VARIABLE

(30) Priority: 18.11.2013 US 201361905475 P
(43) Date of publication of application: 28.09.2016
(73) Proprietor: United Technologies Corporation, Farmington, CT 06032 (US)
(72) Inventor: UCASZ, Mark T., Middleton, CT 06457 (US)
(74) Representative: Dehns
(86) International application number: PCT/US2014/065860
(87) International publication number: WO 2015/073938

(56) References cited:
- EP-A1- 0 808 913
- EP-A1- 1 927 677
- EP-A1- 2 589 681
- EP-A2- 1 712 657
- EP-A2- 1 731 630
- EP-A2- 2 530 185
- EP-B1- 0 951 579
- WO-A1-2014/022285
- US-A- 5 705 231
- US-A1- 2008 241 560
- US-A1- 2011 038 710
- US-A1- 2012 028 055
- US-B1- 6 382 920

## Description

### BACKGROUND

A gas turbine engine typically includes a fan section, a compressor section, a combustor section and a turbine section. Air entering the compressor section is compressed and delivered into the combustion section where it is mixed with fuel and ignited to generate a high-speed exhaust gas flow. The high-speed exhaust gas flow expands through the turbine section to drive the compressor and the fan section. The compressor section typically includes low and high pressure compressors, and the turbine section includes low and high pressure turbines. Airfoils in the engine can be coated with a ceramic thermal barrier coating to protect the airfoils from the high-temperature gas flow.

EP 1731630 A2 discloses a prior art coated article as set forth in the preamble of claim 1.

EP 2 589 681 A1, US 2011/038710 A1, WO 2014/022285 A1, US 6 382 920 B1, EP 0 808 913 A1, EP 2 530 185 A2 and EP 1 927 677 A1 disclose other prior art.

### SUMMARY

According to the present invention, there is provided a coated airfoil as set forth in claim 1.

In an embodiment of the foregoing embodiment, the localized property requirements are selected from the group consisting of thermal conductivity, spallation resistance, environmental resistance, thermochemical resistance, thermomechanical resistance, oxidation resistance, corrosion resistance, erosion resistance, electromagnetic emissions, impact resistance, fracture toughness, hardness, and combinations thereof.

In a further embodiment of any of the foregoing embodiments, the first location L1 predominantly includes yttria stabilized zirconia and the second location L2 predominantly includes gadolinia stabilized zirconia.

In a further embodiment of any of the foregoing embodiments, the ceramic-based coating includes a first location L1 that has a columnar microstructure and a second location L2 that has non-columnar microstructure.

In a further embodiment of any of the foregoing embodiments, the ceramic-based coating varies between a leading edge of the airfoil and another location on the airfoil to provide better impact resistance and erosion resistance at the leading edge relative to the other location on the airfoil and the other locations are provided with better spallation resistance and environmental resistance relative to the leading edge.

In a further embodiment of any of the foregoing embodiments, the composition includes zirconate.

In a further embodiment of any of the foregoing embodiments, the composition includes at least one of alumina-containing ceramic material, mullite, zircon, rare earth silicates, and combinations thereof.

There is further provided a gas turbine engine according to claim 2.

An embodiment of the foregoing embodiment includes a compressor section, a combustor in fluid communication with the compressor section, and a turbine section in fluid communication with the combustor.

In a further embodiment of any of the foregoing embodiments, the localized property requirements are selected from the group consisting of thermal conductivity, spallation resistance, environmental resistance, erosion, and combinations thereof.

In a further embodiment of any of the foregoing embodiments, the ceramic-based coating varies between a leading edge of the airfoil and another location on the airfoil to provide better impact resistance and erosion resistance at the leading edge relative to the other location on the airfoil and the other locations are provided with better spallation resistance and environmental resistance relative to the leading edge.

### BRIEF DESCRIPTION OF THE DRAWINGS

The various features and advantages of the present disclosure will become apparent to those skilled in the art from the following detailed description. The drawings that accompany the detailed description can be briefly described as follows.
Figure 1 illustrates a gas turbine engine.
Figure 2 illustrates a representative portion of a coated article that can be used in the gas turbine engine of Figure 1.
Figure 3 illustrates a representative portion of a multilayered coating structure falling outside the scope of the claims.
Figure 4 illustrates a partially overlapping joint of a coating falling outside the scope of the claims.
Figure 5A illustrates a columnar microstructure of a portion of a ceramic-based coating.
Figure 5B illustrates a non-columnar microstructure of a portion of a ceramic-based coating.
Figure 6 illustrates a coated airfoil that can be used in the gas turbine engine of Figure 1.

### DETAILED DESCRIPTION

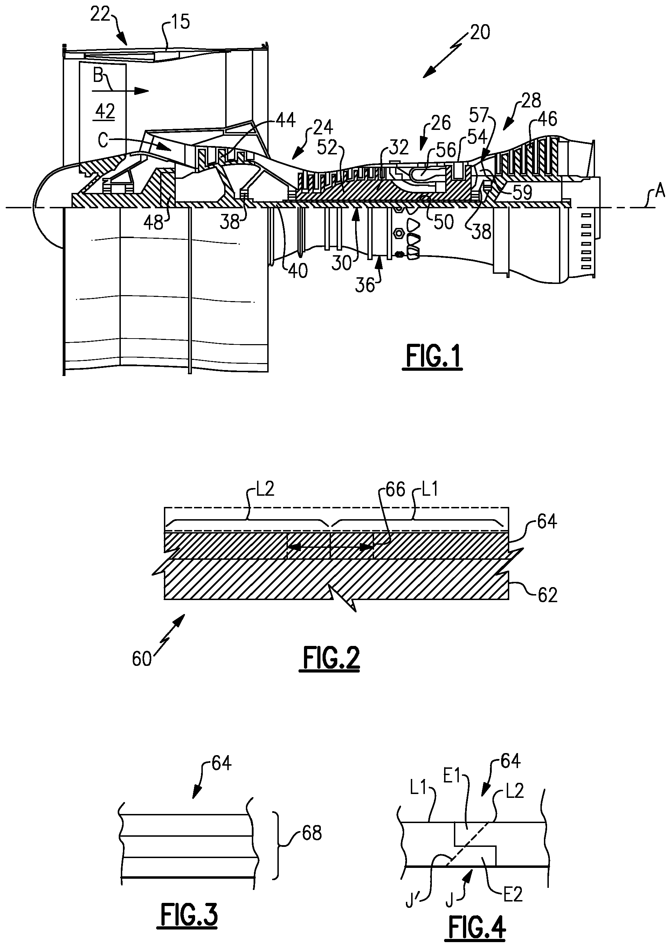

Figure 1 schematically illustrates a gas turbine engine 20. The gas turbine engine 20 is disclosed herein as a two-spool turbofan that generally incorporates a fan section 22, a compressor section 24, a combustor section 26 and a turbine section 28. Alternative engines might include an augmentor section (not shown) among other systems or features. The fan section 22 drives air along a bypass flow path B in a bypass duct defined within a nacelle 15, while the compressor section 24 drives air along a core flow path C for compression and communication into the combustor section 26 then expansion through the turbine section 28. Although depicted as a two-spool turbofan gas turbine engine in the disclosed non-limiting embodiment, it should be understood that the concepts described herein are not limited to use with two-spool turbofans as the teachings may be applied to other types of turbine engines including three-spool architectures.

The exemplary engine 20 generally includes a low speed spool 30 and a high speed spool 32 mounted for rotation about an engine central longitudinal axis A relative to an engine static structure 36 via several bearing systems 38. It should be understood that various bearing systems 38 at various locations may alternatively or additionally be provided, and the location of bearing systems 38 may be varied as appropriate to the application.

The low speed spool 30 generally includes an inner shaft 40 that interconnects a fan 42, a first (or low) pressure compressor 44 and a first (or low) pressure turbine 46. The inner shaft 40 is connected to the fan 42 through a speed change mechanism, which in exemplary gas turbine engine 20 is illustrated as a geared architecture 48 to drive the fan 42 at a lower speed than the low speed spool 30. The high speed spool 32 includes an outer shaft 50 that interconnects a second (or high) pressure compressor 52 and a second (or high) pressure turbine 54. A combustor 56 is arranged in exemplary gas turbine 20 between the high pressure compressor 52 and the high pressure turbine 54. A mid-turbine frame 57 of the engine static structure 36 is arranged generally between the high pressure turbine 54 and the low pressure turbine 46. The mid-turbine frame 57 further supports bearing systems 38 in the turbine section 28. The inner shaft 40 and the outer shaft 50 are concentric and rotate via bearing systems 38 about the engine central longitudinal axis A which is collinear with their longitudinal axes.

The core airflow is compressed by the low pressure compressor 44 then the high pressure compressor 52, mixed and burned with fuel in the combustor 56, then expanded over the high pressure turbine 54 and low pressure turbine 46. The mid-turbine frame 57 includes airfoils 59 which are in the core airflow path C. The turbines 46, 54 rotationally drive the respective low speed spool 30 and high speed spool 32 in response to the expansion. It will be appreciated that each of the positions of the fan section 22, compressor section 24, combustor section 26, turbine section 28, and fan drive gear system 48 may be varied. For example, gear system 48 may be located aft of combustor section 26 or even aft of turbine section 28, and fan section 22 may be positioned forward or aft of the location of gear system 48.

The engine 20 in one example is a high-bypass geared aircraft engine. In a further example, the engine 20 bypass ratio is greater than about six, with an example embodiment being greater than about ten, the geared architecture 48 is an epicyclic gear train, such as a planetary gear system or other gear system, with a gear reduction ratio of greater than about 2.3 and the low pressure turbine 46 has a pressure ratio that is greater than about five. In one disclosed embodiment, the engine 20 bypass ratio is greater than about ten, the fan diameter is significantly larger than that of the low pressure compressor 44, and the low pressure turbine 46 has a pressure ratio that is greater than about five. Low pressure turbine 46 pressure ratio is pressure measured prior to inlet of low pressure turbine 46 as related to the pressure at the outlet of the low pressure turbine 46 prior to an exhaust nozzle. The geared architecture 48 may be an epicycle gear train, such as a planetary gear system or other gear system, with a gear reduction ratio of greater than about 2.3:1. It should be understood, however, that the above parameters are only exemplary of one embodiment of a geared architecture engine and that the present invention is applicable to other gas turbine engines including direct drive turbofans.

A significant amount of thrust is provided by the bypass flow B due to the high bypass ratio. The fan section 22 of the engine 20 is designed for a particular flight condition -- typically cruise at about 0.8 Mach and about 35,000 feet (10,668 m). The flight condition of 0.8 Mach and 35,000 ft (10,668 m), with the engine at its best fuel consumption - also known as "bucket cruise Thrust Specific Fuel Consumption ('TSFC')" - is the industry standard parameter of lbm of fuel being burned divided by lbf of thrust the engine produces at that minimum point.
"Low fan pressure ratio" is the pressure ratio across the fan blade alone, without a Fan Exit Guide Vane ("FEGV") system. The low fan pressure ratio as disclosed herein according to one non-limiting embodiment is less than about 1.45. "Low corrected fan tip speed" is the actual fan tip speed in ft/sec divided by an industry standard temperature correction of [(Tram °R) / (518.7 °R)]^{0.5} (where °R = K x 9/5). The "Low corrected fan tip speed" as disclosed herein according to one non-limiting embodiment is less than about 1150 ft / second (350.5 m/s).

Figure 2 illustrates a representative portion of a coated airfoil, such as a blade or vane. In other examples falling outside the scope of the claims, the article 60 may be a blade outer air seal, a rotor disk, combustor panel, augmentor liner or other article that would benefit from the examples disclosed herein. The disclosure is not limited to gas turbine engine articles, and it is to be understood that the disclosure can also be applied in other machines or systems, such as but not limited to internal combustion engines for articles such as turbo chargers, manifolds, exhaust pipes, and waste gates. The airfoil 60 includes a substrate 62 and a continuous ceramic-based coating 64 supported on the substrate 62. The substrate 62 can be a structural body of the airfoil or an intermediate coating that is between the ceramic-based coating 64 and a structural body of the airfoil, for example.

The chemical composition and the microstructure of the ceramic-based coating 64 varies by location on the substrate 62 with respect to localized property requirements. For example, as shown in Figure 2, the ceramic-based coating 64 has a first composition and microstructure at location L1 and a second composition and microstructure at location L2 lateral of location L1.

The composition and the microstructure of the ceramic-based coating 64 vary by location to tailor the properties of the ceramic-based coating 64 according to localized property requirements. For example, the airfoil 60 can have different localized requirements for thermal conductivity, spallation resistance, environmental resistance (oxidation, thermochemical, thermomechanical and corrosion resistance), electromagnetic emissions, impact resistance, fracture toughness, erosion resistance, hardness, or combinations thereof. By varying the composition, microstructure, or both, between different locations on the airfoil 60, the localized property requirements can be tailored to the particular locations and thus can enhance the desired properties instead of durability of the airfoil 60.

In one example of a varying composition of the ceramic-based coating 64, the first location L1 predominantly includes yttria stabilized zirconia (YSZ) and the second location L2 predominantly includes gadolinia stabilized zirconia (GSZ). Alternatively, other ceramic compositions or other compositions of zirconia or partially or fully stabilized zirconia can be used. In a further example, the YSZ includes 6-22 wt% yttria and, for instance, can include 7 wt% yttria. The GSZ can include 25-64 wt% gadolinia and, for instance, can include 59 wt% gadolinia. The YSZ can provide higher fracture toughness than GSZ, and GSZ can provide a lower thermal conductivity than YSZ.

In further examples, the composition of the ceramic-based coating 64 at the first location L1 or the second location L2 can include cubic/fluorite/pyrochlore/delta phase fully stabilized zirconates, where stabilizers are any oxide or mix of oxides including lanthanide series elements Y, Sc, Mg, Ca, or further modified with Ta, Nb, Ti, Hf. One example composition is gadolinia stabilized zirconia of having a composition Gd₂Zr₂O₇ and compositions disclosed in U.S. Pat. Nos. 6,117,560 and 6,177,200.

In further examples, the composition of the ceramic-based coating 64 at the first location L1 or the second location L2 can include alumina-containing ceramic material, mullite, zircon (ZrSiO₄), rare earth silicates, combinations of at least one of the foregoing, and the like. Example rare earth silicates can include, but are not limited to, yttrium silicate, yttrium disilicate, magnesium aluminate spinel, and the like.

The ceramic-based coating 64 has a functionally graded region 66 (laterally graded) between the first location L1 and the second location L2. The functionally graded region 66 is a compositional transition from the composition of the ceramic-based coating in the first location L1 to the composition of the ceramic-based coating 64 in the second location L2. In one example, the composition transitions from YSZ in the first location L1 to GSZ in the second location L2.

In an example falling outside the scope of the claims, the ceramic-based coating 64 has a functionally graded composition at the first location L1 and a homogenous composition at the second location L2. For instance, the composition in the first location L1 gradually changes as a function of distance from the surface of the substrate 62, while the composition in the second location L2 is constant or substantially constant as a function of distance from the surface of the substrate 62.

In another example falling outside the scope of the claims, shown in part in Figure 3, the ceramic-based coating 64 can have a multilayered structure, represented at 68, in the first location LI, with distinct layers of differing compositions, and a homogenous composition in the second location L2. For instance, the first location L1 can include alternating YSZ/GSZ layers, but the layers are not limited to these compositions, and the second location L2 can include a homogenous composition of YSZ or GSZ.

In another example falling outside the scope of the claims, shown in part in Figure 4, the ceramic-based coating 64 can have a first composition in the first location L1 and a second, different composition in the second location L2, with respective edges E1 and E2 of the first location and the second location partially overlapping at joint (J). The overlapping joint prevents a gap where the locations L1 and L2 meet. Alternatively, the edges F1 and E2 can overlap at a sloped interface, represented at J', such as a 45° angle interface.

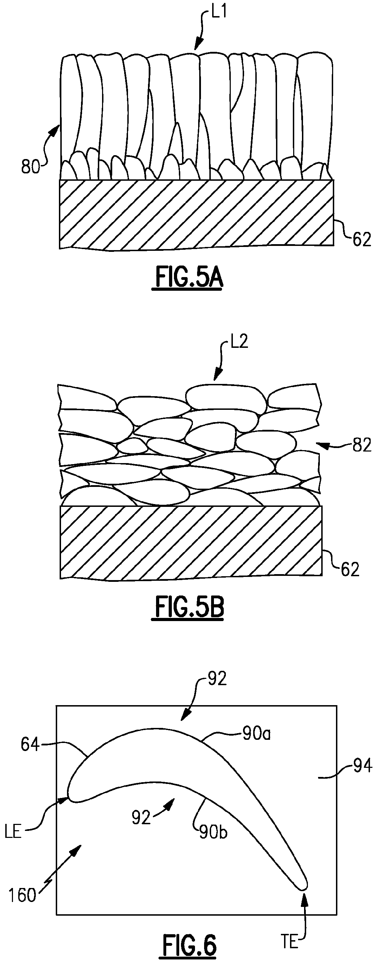

In a further example shown in Figures 5A and 5B, the ceramic-based coating 64 varies in microstructure, and can have a columnar microstructure 80 in the first location L1 and a non-columnar microstructure 82 in the second location L2. In the columnar microstructure 80, the grains of the ceramic material are oriented with long axes oriented in a controlled angle relative to the surface of the substrate 62, such as substantially perpendicular to the surface of the substrate 62. In the non-columnar microstructure 82, the grains are not oriented with long axes perpendicular to the surface of the substrate 62. In this example, the grains of the non-columnar microstructure 82 are oriented with long axes parallel to the surface of the substrate 62.

For example, the columnar microstructure 80 and the non-columnar microstructure 82 are representative of the deposition techniques used to deposit those portions of the ceramic-based coating 64. For instance, the columnar microstructure 80 is representative of deposition by electron beam physical vapor deposition (EBPVD), suspension plasma spray (SPS), plasma spray or by other methods and the non-columnar microstructure 82 is representative of plasma spray deposition, such as air plasma spray. The microstructures 80/82 can provide different properties between the first and second locations L1/L2. As an example, for a given ceramic material, the columnar microstructure 80 can provide better fatigue resistance and the non-columnar microstructure 82 can provide better thermal resistance. Other non-limiting examples of differences in microstructures can include differences in physical characteristics, porosity, crystallographic orientation, deposition splat size, column geometry, and combinations thereof.

Figure 6 illustrates another example coated airfoil that can be used in the gas turbine engine 20. For example, the airfoil 160 can be a turbine airfoil in the turbine section 28 of the engine 20, but is not limited to turbine airfoils. In this example, the airfoil 160 includes the ceramic-based coating 64 continuously supported on the outer surface thereof. The airfoil 160 has a leading edge LE and a trailing edge TE that are joined by opposed first and second sides 90a/90b. The leading edge of the airfoil 160 can be susceptible to high temperatures and impact from foreign objects in the gas stream that flows across the surfaces of the airfoil 160. Thus, the ceramic-based coating 64 varies in composition and microstructure between the leading edge of the airfoil 160 and the other locations of the airfoil 160, represented at 92, to provide better impact resistance and erosion resistance at the leading edge relative to the other locations 92 on the airfoil 160. For example, the leading edge (location LI) and platform 94 can have a homogeneous YSZ composition for better impact and erosion resistance and the other areas 92 (location L2) can have a functionally graded YSZ/GSZ composition for better thermal protection.

Although a combination of features is shown in the illustrated examples, not all of them need to be combined to realize the benefits of various embodiments of this disclosure. In other words, a system designed according to an embodiment of this disclosure will not necessarily include all of the features shown in any one of the Figures or all of the portions schematically shown in the Figures. Moreover, selected features of one example embodiment may be combined with selected features of other example embodiments.

The preceding description is exemplary rather than limiting in nature. Variations and modifications to the disclosed examples may become apparent to those skilled in the art that do not necessarily depart from the essence of this disclosure. The scope of legal protection given to this disclosure can only be determined by studying the following claims.

## Claims

1. An airfoil (60; 160) comprising:
a substrate (62); and
a continuous ceramic-based coating (64) supported on the substrate (62), the ceramic-based coating (64) varying in composition and in microstructure by location on the substrate (62) and with respect to localized property requirements;
**characterised in that**:
the ceramic-based coating (64) has a functionally graded region (66),
wherein the functionally graded region (66) is a compositional transition from a first composition of the ceramic-based coating (64) at a first location L1 to a second composition of the ceramic-based coating (64) at a second location L2.

2. A gas turbine engine (20) comprising the airfoil (60; 160) of claim 1.

3. The gas turbine engine as recited in claim 2, wherein the ceramic-based coating (64) varies in coating architecture by location on the substrate (62) with respect to localized property requirements.

4. The gas turbine engine as recited in claim 2 or 3, including a compressor section (24), a combustor (56) in fluid communication with the compressor section (24), and a turbine section (28) in fluid communication with the combustor (56).

5. The airfoil or gas turbine engine as recited in any preceding claim, wherein the localized property requirements are selected from the group consisting of thermal conductivity, spallation resistance, environmental resistance, thermochemical resistance, thermomechanical resistance, oxidation resistance, corrosion resistance, erosion resistance, electromagnetic emissions, impact resistance, fracture toughness, hardness, and combinations thereof.

6. The airfoil or gas turbine engine as recited in any preceding claim, wherein the first location L1 predominantly includes yttria stabilized zirconia and the second location L2 predominantly includes gadolinia stabilized zirconia.

7. The airfoil or gas turbine engine as recited in any preceding claim, wherein the first location L1 has a columnar microstructure (80) and the second location L2 has non-columnar microstructure (82).

8. The airfoil or gas turbine engine as recited in any preceding claim, wherein the ceramic-based coating (64) varies between a leading edge (LE) of the airfoil (160) and another location (92) on the airfoil (160) by varying the composition and microstructure between the leading edge (LE) and the other location (92) to provide better impact resistance and erosion resistance at the leading edge (LE) relative to the other location (92) on the airfoil (160) and the other locations (92) are provided with better spallation resistance and environmental resistance relative to the leading edge (LE).

9. The airfoil or gas turbine engine as recited in any preceding claim, wherein the composition includes zirconate.

10. The airfoil or gas turbine engine as recited in any preceding claim, wherein the composition includes at least one of alumina-containing ceramic material, mullite, zircon, rare earth silicates, and combinations thereof.

## Patentansprüche

1. Schaufelblatt (60; 160), umfassend:
ein Substrat (62); und
eine durchgehende keramikbasierte Beschichtung (64), die auf dem Substrat (62) getragen wird, wobei die keramikbasierte Beschichtung (64) in Zusammensetzung und Mikrostruktur durch die Position auf dem Substrat (62) und in Bezug auf örtlich begrenzte Eigenschaftsanforderungen variiert,
**dadurch gekennzeichnet, dass**
die keramikbasierte Beschichtung (64) einen funktional abgestuften Bereich (66) aufweist, wobei der funktional abgestufte Bereich (66) ein Zusammensetzungsübergang von einer ersten Zusammensetzung der keramikbasierten Beschichtung (64) an einer ersten Position L1 zu einer zweiten Zusammensetzung der keramikbasierten Beschichtung (64) an einer zweiten Position L2 ist.

2. Gasturbinentriebwerk (20), welches das Schaufelblatt (60; 160) nach Anspruch 1 umfasst.

3. Gasturbinentriebwerk nach Anspruch 2, wobei die keramikbasierte Beschichtung (64) im Beschichtungsaufbau durch die Position auf dem Substrat (62) in Bezug auf die örtlich begrenzten Eigenschaftsanforderungen variiert.

4. Gasturbinentriebwerk nach Anspruch 2 oder 3, das einen Verdichterbereich (24), eine Brennkammer (56) in Fluidverbindung mit dem Verdichterbereich (24) und einen Turbinenbereich (28) in Fluidverbindung mit der Brennkammer (56) beinhaltet.

5. Schaufelblatt oder Gasturbinentriebwerk nach einem der vorhergehenden Ansprüche, wobei die örtlich begrenzten Eigenschaftsanforderungen aus der Gruppe ausgewählt sind, die aus Wärmeleitfähigkeit, Spallationsbeständigkeit, Umgebungsbeständigkeit, thermochemischer Beständigkeit, Oxidationsbeständigkeit, Korrosionsbeständigkeit, Erosionsbeständigkeit, elektromagnetischen Emissionen, Aufprallbeständigkeit, Bruchfestigkeit, Härtegrad und Kombinationen daraus besteht.

6. Schaufelblatt oder Gasturbinentriebwerk nach einem der vorherigen Ansprüche, wobei die erste Position L1 vorwiegend mit Yttriumoxid stabilisiertes Zirkoniumdioxid beinhaltet und die zweite Position L2 vorwiegend mit Gadoliniumoxid stabilisiertes Zirkoniumdioxid beinhaltet.

7. Schaufelblatt oder Gasturbinentriebwerk nach einem der vorherigen Ansprüche, wobei die erste Position L1 eine säulenförmige Mikrostruktur (80) aufweist und die zweite Position L2 eine nichtsäulenförmige Mikrostruktur (82) aufweist.

8. Schaufelblatt oder Gasturbinentriebwerk nach einem der vorherigen Ansprüche, wobei die keramikbasierte Beschichtung (64) zwischen einer Vorderkante (leading edge - LE) des Schaufelblatts (160) und einer anderen Position (92) auf dem Schaufelblatt (160) durch das Variieren der Zusammensetzung und der Mikrostruktur zwischen der Vorderkante (LE) und der anderen Position (92) variiert, um eine bessere Aufprallbeständigkeit und Erosionsbeständigkeit an der Vorderkante (LE) relativ zur anderen Position (92) auf dem Schaufelblatt (160) bereitzustellen und die anderen Positionen (92) mit besserer Spallationsbeständigkeit und Umgebungsbeständigkeit relativ zur Vorderkante (LE) bereitgestellt sind.

9. Schaufelblatt oder Gasturbinentriebwerk nach einem der vorherigen Ansprüche, wobei die Zusammensetzung Zirkoniumdioxid beinhaltet.

10. Schaufelblatt oder Gasturbinentriebwerk nach einem der vorherigen Ansprüche, wobei die Zusammensetzung mindestens eines von aluminiumoxidenthaltendem Keramikmaterial, Mullit, Zirkon, Seltenerdsilikaten und Kombinationen daraus beinhaltet.

## Revendications

1. Profil d'aube (60 ; 160) comprenant :
un substrat (62) ; et
un revêtement à base de céramique continu (64) supporté par le substrat (62), le revêtement à base de céramique (64) variant en composition et en microstructure en fonction de l'emplacement sur le substrat (62) et par rapport aux exigences de propriété localisées,
**caractérisé en ce que**
le revêtement à base de céramique (64) a une région calibrée de manière fonctionnelle (66), dans lequel la région calibrée de manière fonctionnelle (66) est une transition de composition d'une première composition du revêtement à base de céramique (64) au niveau d'un premier emplacement L1 à une seconde composition du revêtement à base de céramique (64) au niveau d'un second emplacement L2.

2. Moteur à turbine à gaz (20) comprenant le profil d'aube (60 ; 160) selon la revendication 1.

3. Moteur à turbine à gaz selon la revendication 2, dans lequel le revêtement à base de céramique (64) a une architecture de revêtement variable en fonction de l'emplacement sur le substrat (62) par rapport aux exigences de propriété localisées.

4. Moteur à turbine à gaz selon la revendication 2 ou 3, incluant une section de compresseur (24), une chambre de combustion (56) en communication fluidique avec la section de compresseur (24), et une section de turbine (28) en communication fluidique avec la chambre de combustion (56).

5. Profil d'aube ou moteur à turbine à gaz selon une quelconque revendication précédente, dans lequel les exigences de propriété localisées sont choisies dans le groupe constitué de la conductivité thermique, la résistance à la spallation, la résistance environnementale, la résistance thermochimique, la résistance thermomécanique, la résistance à l'oxydation, la résistance à la corrosion, la résistance à l'érosion, les émissions électromagnétiques, la résistance aux chocs, la ténacité, la dureté, et des combinaisons de celles-ci.

6. Profil d'aube ou moteur à turbine à gaz selon une quelconque revendication précédente, dans lequel le premier emplacement L1 inclut principalement de la zircone stabilisée par de l'oxyde d'yttrium et le second emplacement L2 inclut principalement de la zircone stabilisée par de l'oxyde de gadolinium.

7. Profil d'aube ou moteur à turbine à gaz selon une quelconque revendication précédente, dans lequel le premier emplacement L1 a une microstructure colonnaire (80) et le second emplacement L2 a une microstructure non colonnaire (82).

8. Profil d'aube ou moteur à turbine à gaz selon une quelconque revendication précédente, dans lequel le revêtement à base de céramique (64) varie entre un bord d'attaque (LE) du profil d'aube (160) et un autre emplacement (92) sur le profil d'aube (160) en fonction de la variation de la composition et de la microstructure entre le bord d'attaque (LE) et l'autre emplacement (92) pour permettre une meilleure résistance aux chocs et résistance à l'érosion au niveau du bord d'attaque (LE) par rapport à l'autre emplacement (92) sur le profil d'aube (160) et les autres emplacements (92) sont dotés d'une meilleure résistance à la spallation et résistance environnementale par rapport au bord d'attaque (LE).

9. Profil d'aube ou moteur à turbine à gaz selon une quelconque revendication précédente, dans lequel la composition inclut du zirconate.

10. Profil d'aube ou moteur à turbine à gaz selon une quelconque revendication précédente, dans lequel la composition inclut au moins l'un parmi matériau céramique contenant de l'alumine, mullite, zircon, silicates de terres rares et combinaisons de ceux-ci.
